Europäisches Patentamt

European Patent Office

Office européen des brevets

(19)

(11) **EP 1 298 965 A2**

(12) **EUROPEAN PATENT APPLICATION**

(43) Date of publication:
**02.04.2003 Bulletin 2003/14**

(51) Int Cl.$^7$: **H05G 2/00**

(21) Application number: **02017814.1**

(22) Date of filing: **07.08.2002**

(84) Designated Contracting States:
**AT BE BG CH CY CZ DE DK EE ES FI FR GB GR
IE IT LI LU MC NL PT SE SK TR**
Designated Extension States:
**AL LT LV MK RO SI**

(30) Priority: **07.08.2001 JP 2001239020**

(71) Applicant: **Nikon Corporation
Tokyo 100-8831 (JP)**

(72) Inventors:
 • **Kondo, Hiroyuki, c/o Nikon Corporation
Chiyoda-ku, Tokyo 100 (JP)**

 • **Murakami, Katsuhiko, c/o Nikon Corporation
Chiyoda-ku, Tokyo 100 (JP)**

(74) Representative: **Meddle, Alan Leonard
FORRESTER & BOEHMERT,
Pettenkoferstrasse 20-22
80336 München (DE)**

Remarks:
Claims 14-22 and 24-31 are deemed to be abandoned due to non-payment of the claims fees (Rule 31 (2) EPC).

(54) **Radiation-generating devices utilizing multiple plasma-discharge sources and microlithography apparatus and methods utilizing the same**

(57)    Radiation-generating devices are disclosed that are suitable for use in a microlilhography apparatus. The devices utilize multiple plasma-discharge radiation sources (e.g., capillary discharge X-ray sources) and produce a high output with a high repeat frequency while minimizing the thermal loads to which the individual radiation sources are subjected. In one embodiment, multiple radiation sources (discharge units) are coupled to a movable substrate, such as a rotary plate. The movable substrate can be controlled such that a selected one of the multiple discharge units can be moved into a discharge position and aligned along a discharge axis. The device may also include a preliminary-ionization source facing the discharge axis. Alternatively, multiple preliminary4onization sources may be coupled to the movable substrate such that a selected one of the preliminary ionization sources energizes the target gas in the selected discharge unit.

FIG. 1(A)

**EP 1 298 965 A2**

## Description

## Field

This disclosure pertains to microlithography (projection-transfer of a pattern, defined on a reticle, onto a suitable substrate) and related technologies. Microlithography is a key technology used in the manufacture of microelectronic devices such as integrated circuits, magnetic-recording heads, displays, and micromachines. More specifically, the disclosure pertains to radiation sources that generate, for example, X-ray radiation and may be used in an X-ray microlithography apparatus, an X-ray microscope, an X-ray analysis device, or the like.

## Background

A plasma-discharge X-ray source generates X-ray radiation by positioning a target gas between two electrodes and subjecting the material to a high-current electric discharge. The inter-electrode electric discharge creates a plasma from the target gas that eventually becomes sufficiently energized to produce X-ray radiation. Plasma-discharge X-ray sources are small, produce a large X-ray flux, convert input electrical energy into X-rays at a high efficiency, and are inexpensive.

Several types of plasma-discharge X-ray sources are known, including Z-pinch plasma X-ray sources, capillary discharge X-ray sources, and plasma-focus X-ray sources. These plasma-discharge X-ray sources all generate hot plasma from the target gas by generating a large current flow between electrodes. The large current flowing through the generated plasma also flows through the electrodes, causing an increase in the temperature of the electrodes. The plasma generated in the vicinity of the electrodes also contributes to the heating of the electrodes. The increase in electrode temperature is especially pronounced in situations where the repeat frequency of the source is high. Additionally, for plasma-discharge X-ray sources that generate wavelengths in the soft X-ray region, the source is typically enclosed in a vacuum chamber having a reduced atmospheric pressure in order to minimize the absorption of the emitted X-rays by the gas surrounding the plasma. This arrangement prevents the heat of the electrodes from being dissipated by convection or thermal conduction. The repeated heating of the electrodes without a sufficient cooling mechanism presents a significant problem and may ultimately lead to the melting of the electrodes.

Plasma-discharge X-ray sources are commonly utilized in X-ray steppers. The reflectivity of the multilayer-film mirrors used in the optical elements of the X-ray steppers, however, is relatively low (*e.g.*, around 70%). Thus, a high-output X-ray source must be used. For example, for an X-ray stepper using an X-ray beam having a wavelength of 13.4 ± 0.3 nm, an X-ray beam having a power of 50-150W is required. In order to increase the power of the X-ray beam generated from a plasma-discharge X-ray source, the source must have a high repeat frequency. Further, a high repeat frequency (e.g., 1-10 KHz) may be necessary for X-ray steppers that operate in a scanning motion while illuminating the reticle. This scanning motion can be used to ensure the uniformity of the exposure dose across the illumination region.

Conventional plasma-discharge X-ray generators utilize only one discharge unit (*i.e.*, a single pair of discharge electrodes) and cannot produce such high output with the required degree of repeatability without melting the electrodes. As a result, conventional X-ray sources are not practical for many of the microlithography applications discussed above.

## Summary

In view of the shortcomings of the prior art as summarized above, the present disclosure provides, *inter alia,* radiation-generating devices exhibiting, compared to conventional generators, both a high output and a high repeat frequency. The devices also minimize the thermal load to which the plasma-discharge sources used in the device are subjected. In general, the devices utilize multiple plasma-discharge sources (discharge units) that are controllable and can be moved into one or more discharge positions. Upon being positioned in the discharge position, the selected discharge unit may be energized and emit radiation. By utilizing multiple discharge units, the emission frequency from such a device can be increased without increasing the repeat frequency of any individual discharge unit, thereby minimizing the load that is applied to the electrodes of an individual discharge unit. The devices are suitable for use in, among other things, microlithography exposure apparatus. The discharge units may be configured to emit X-ray radiation or other types of radiation.

According to a first aspect of the invention, multiple discharge units coupled to a movable substrate are provided. In an embodiment, the discharge units include first and second electrodes situated relative to each other such that an electrical current applied across the electrodes forms a plasma from a target gas positioned between the electrodes and causes the plasma to emit radiation. The movable substrate can be controlled such that a selected one of the multiple discharge units can be moved into a discharge position and aligned along a discharge axis. The device may also include a synchronization mechanism configured to control the timing with which the current is applied to the multiple discharge units so that the current is applied only to the selected discharge unit.

The device may also include a preliminary-ionization source facing the discharge axis. The preliminary-ionization source is configured to energize the target matter in the selected discharge unit. Alternatively, multiple preliminary-ionization sources may be coupled to the movable substrate and situated relative to the selected discharge unit such that a selected one of the preliminary-ionization sources energizes the target gas in the selected discharge unit. The selected preliminary-ionization source may be configured to provide preliminary ionization for multiple discharge units on the movable substrate. A discharge circuit may also be provided that is connected to the electrodes and preliminary-ionization source(s) and that is configured to delay the delivery of the discharge current to the electrodes of the selected discharge unit until after the preliminary-ionization source has been energized.

A second aspect of the invention is similar to the first except that multiple movable substrates are provided to which one or more discharge units are coupled. The movable substrates can be controlled such that a selected one of the multiple discharge units can be moved into a discharge position.

A third aspect of the invention is also similar to the first, except that the movable substrate to which the multiple discharge units are coupled is a rotary plate. The rotary plate can be controlled such that a selected one of the discharge units can be rotated into a discharge position. The rotary plate allows the selected discharge unit to be quickly moved into the discharge position. The rotary plate may define a hollow interior that is fluidly connected to two rotary axes coupled to the rotary plate and configured to transport a fluid, such as a coolant. A pump and a heat exchanger may also be fluidly connected with the rotary axes. The fluid can be circulated through the rotary axes, the rotary plate, and the heat exchanger, thereby cooling the discharge units. The cooling mechanism further minimizes deterioration of the discharge units. A flow-straightener may also be provided inside the hollow interior of the rotary plate. The flow-straightener desirably has a vane configuration suitable for directing the circulating fluid toward the radial ends of the rotary plate where the discharge units are located. The rotary plate may also be positioned within a cover encompassing the plate. The cover may include a gas inlet for introducing the target gas used to fill the discharge units. In one embodiment, the discharge position of the device may be a discharge area larger than a single position. The selected discharge unit may then emit radiation in a scanning motion across the discharge area. In another embodiment, multiple discharge positions may be provided. The discharge units may then be configured to discharge radiation simultaneously from multiple discharge units positioned in the multiple discharge positions.

In a fourth aspect of the invention, microlithography apparatus utilizing any of the devices or embodiments described above are provided.

In a fifth aspect of the invention, microelectronic devices manufactured by an apparatus using any of the devices of embodiments described above are provided.

In a sixth aspect of the invention, methods for operating the devices described in the above embodiments are provided.

The foregoing and additional features and advantages of the invention will be more readily apparent from the following detailed description, which proceeds with reference to the accompanying drawings.

## Brief Description of the Drawings

FIG. 1(A) is an oblique view schematically showing an X-ray generator according to a first embodiment.

FIG. 1(B) is a cross-sectional view showing in greater detail the discharge unit of the X-ray generator shown in FIG. 1(A).

FIG. 2 is a cross-sectional view schematically showing the overall structure of an X-ray generator according to a second embodiment.

FIG. 3(A) is a front view of a rotary plate located within the X-ray generator shown in FIG. 2.

FIG. 3(B) is a lateral cross-sectional view showing an exemplary capillary of a discharge unit attached to the rotary plate shown in FIG. 3(A).

FIG. 4(A) is a cross-sectional view schematically showing the overall structure of an X-ray generator according to a third embodiment.

FIG. 4(B) is a cross-sectional front view of a rotary plate used in the X-ray generator shown in FIG. 4(A).

FIG. 5 is a circuit diagram for a main discharge circuit that may be used with the second and third representative embodiments.

FIG. 6(A) is cross-sectional view schematically showing a discharge unit and capacitor mounted onto a rotary plate in accordance with a fourth representative embodiment.

FIG. 6(B) is a front view of the rotary plate on which the discharge units and capacitors shown in FIG. 6(A) are mounted.

FIG. 7(A) is a circuit diagram for a main discharge circuit having separate capacitors for each discharge unit wherein spark discharges are used for the preliminary-ionization source.

FIG. 7(B) is a circuit diagram for a main discharge circuit having separate capacitors for each discharge unit, wherein corona discharges are used for the preliminary-ionization source.

FIG. 8 is a front view of a rotary plate according to a fifth embodiment.

FIG. 9 is a cross-sectional view schematically showing an X-ray stepper according to a sixth embodiment.

FIG. 10(A) is a cross-sectional view schematically showing the overall structure of an X-ray generator according to a seventh embodiment.

FIG. 10(B) is a front view of a rotary plate used in the X-ray generator shown in FIG. 10(A).

FIG. 10(C) is a front view of a rotary screen used in the X-ray generator shown in FIG. 10(A).

FIG. 11 is a flowchart of steps in a process for manufacturing a microelectronic device, the process including performing microlithography using an X-ray generating device according to any of the disclosed embodiments.

## Detailed Description

This invention is described below in connection with representative embodiments that are not intended to be limiting in any way. The embodiments are described below as utilizing plasma-discharge sources (discharge units) that emit X-ray radiation. It will be understood, however, that discharge units emitting other forms of radiation may be used.

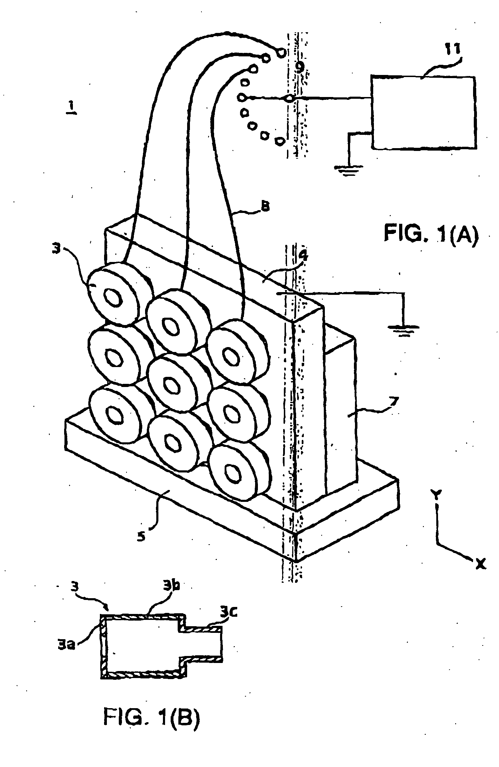

FIGS. 1(A) and 1(B) show an X-ray generator 1 according to a first representative embodiment. The X-ray generator 1 comprises multiple discharge units 3. In the illustrated example, nine discharge units are shown, but it is understood that various other quantities of discharge units may be present. Each discharge unit 3 is a hollow cathode-type unit. As illustrated in FIG. 1 (B), the discharge unit 3 has a ring electrode 3a and a tube-shaped, guarded electrode 3c. The two electrodes 3a and 3c are separated by an insulator tube 3b. By filling the tube 3b with an appropriate target gas (e.g., xenon gas) and subjecting the target gas to electric discharges produced between the electrodes 3a and 3c, plasma is produced that generates X-ray radiation. The discharge units 3 are disposed on a rectangular substrate 4. In the illustrated example, the nine discharge units are positioned in three columns with three discharge units per column. The substrate 4 is connected to a Y-axis stage 7. The Y-axis stage 7 is connected to an X-axis stage 5. The Y-axis stage 7 and X-axis stage 5 are driven by respective stepping motors configured to move the stages across a fixed distance in the respective axial directions. In this manner, the discharge units 3 disposed on the substrate 4 may be moved a fixed distance along the X- and Y-axes. The cathode side of each discharge unit 3 (*i.e.*, the guarded electrode 3c) is electrically connected to the grounded substrate 4. Correspondingly, the anode side of each discharge unit 3 (*i.e.*, the ring electrode 3a) is connected to a respective cable 8. Each cable 8 is connected to a high-voltage power supply 11 via a switch 9.

During operation of the X-ray generator 1, the X-axis stage 5 and/or the Y-axis stage 7 align a selected discharge unit 3 into a prescribed discharge position. Once the selected discharge unit 3 is placed in the prescribed discharge position, the switch 9 connects the selected discharge unit 3 to a high-voltage power supply 11, thereby delivering an electrical current to the selected discharge unit. The current creates an electric discharge between the electrodes of the selected discharge unit 3, thereby producing a plasma and causing the emission of X-ray radiation. The discharge unit may discharge multiple times (e.g., 10 cycles) in the discharge position over a relatively short period of time (e. g., 1 ms). After a prescribed amount of time, the switch 9 is turned off and the discharge unit 3 is disconnected from the power supply 11. The stages 5 and 7 then operate to align the next selected discharge unit 3 into the prescribed discharge position, or into another discharge position, and the process is repeated. This process is typically performed on all discharge units. It is understood that the order in which the discharge units are energized can be set in any sequence. If the total number of discharge units is N and a prescribed number of total discharges is defined for the X-ray generator, then the repeat frequency of each individual discharge unit can be reduced by $\frac{1}{N}$. Consequently, the thermal load on each discharge unit can be reduced, and the extent to which the electrodes of the discharge units deteriorate can be minimized. Thus, the discharge units can operate at higher discharge currents and produce higher outputs during X-ray emission.

It is understood that the illustrated embodiment is not intended to be limiting in any way and may be modified by one skilled in the art without departing from the principles of the disclosed technology. For example, the method of applying current to the electrodes of the discharge units may be performed in various ways. For instance, instead of using the switch 9 to energize a selected discharge unit, the X-ray generator may be configured such that preliminary ionization occurs only on discharge units located in certain discharge positions. In such a configuration, a preliminary-ionization source may be utilized and the anode electrodes of the discharge units can be wired together into a common connected state, thereby eliminating the need for the switches 9. Additionally, instead of coupling the multiple discharge units to a single movable stage, multiple substrates having one or more discharge units may be used.

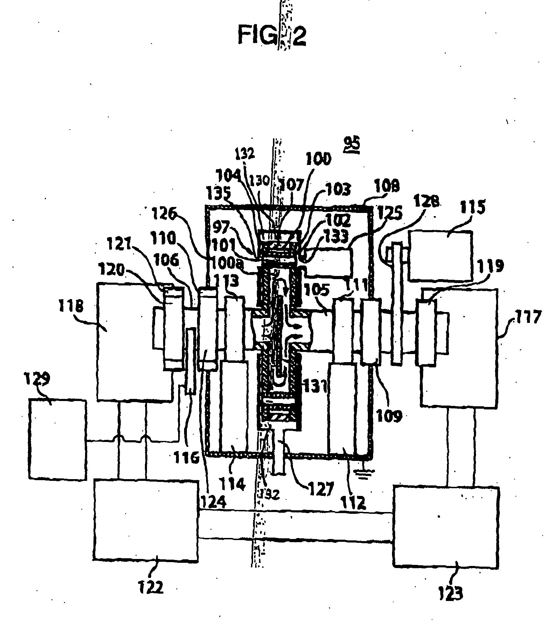

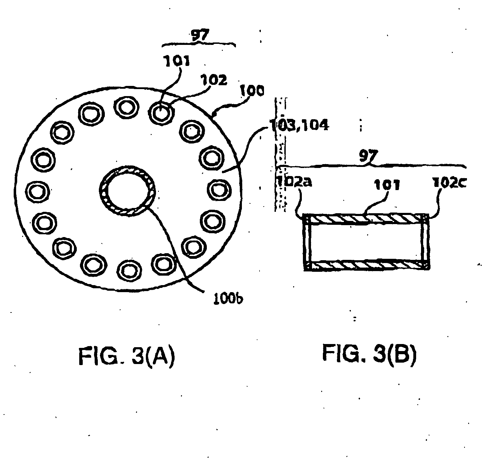

FIGS. 2, 3(A), and 3(B) show an X-ray generator 95 according to a second representative embodiment. The X-ray generator 95 comprises multiple discharge units 97. As more fully discussed below, each of the discharge units 97 is a capillary-discharge X-ray source. As illustrated in FIG. 3(A), sixteen discharge units 97 are disposed on a circle concentric with a rotary plate 100. As shown in FIG. 2, the rotary plate 100 is a hollow body that comprises a first disc 103 and a second disc 104. The discs 103, 104 comprise respective flat disc-shaped plates positioned opposite of and parallel to one another. The discs 103, 104 are connected to each other by a "ring wall" (ring-shaped wall) 107, which extends perpendicularly from the outer periphery of the plates, thereby forming a hollow interior 100a. The discs 103, 104 may be made of a conducting metal, such as copper. The ring wall 107 may be made of an insulating material, such as ceramic, that electrically insulates the discs 103, 104 from one another. In one specific embodiment, the discs 103, 104 are constructed of copper and the ring wall 107 is constructed of $Al_2O_3$. In another specific embodiment, the discs 103 and 104 have an outer diameter of 150 mm and are separated by the ring wall 107 at a distance of 15 mm.

As shown in FIG. 3(A), an opening 100b is located in the center of each of the discs 103, 104. As shown in FIG. 2, hollow cylindrical rotary axes 105, 106 are connected to the openings 100b of the respective discs such that the hollow interior 100a extends through the openings 100b and into the interior of the rotary axes 105, 106. The rotary axes 105, 106 extend axially outward from the two discs 103, 104 and may be affixed onto the discs by either welding or uni-body molding, for example. A flow-straightener 131 may be positioned within the hollow interior 100a of the rotary plate 100 parallel to the discs 103, 104. The diameter of the flow-straightener 131 is smaller than that of the discs 103, 104. The purpose and use of the flow-straightener 131 are discussed below.

As shown in FIG. 3(B), each of the discharge units 97 positioned on the rotary plate 100 comprises a hollow cylindrical capillary 101. A ring anode 102a and a ring cathode 102c (together referred to as the "ring electrodes") are formed at the tips of the capillary 101. Each capillary 101 has a fixed length, which extends through the hollow interior 100a of the rotary plate 100. The capillary 101 may be made of ceramic (e.g., SiC) and, in one embodiment, has an inner diameter of 2 mm, an outer diameter of 5 mm, and a length of 15 mm. The ring anode 102a may be electrically connected to the second disc 104, and the ring cathode 102c may be electrically connected to the first disc 103. The ring electrodes 102a, 102c may be made of molybdenum.

As shown in FIG. 2, the rotary plate 100 is disposed inside a vacuum chamber 108. The rotary axis 105 (shown in FIG. 2 as extending axially to the right from the disc 103) extends through a rotary bearing 111 supported by a stand 112. The stand 112 supports the rotary axis 105. Similarly, the rotary axis 106 (shown in FIG. 2 as extending axially to the left from the disc 104) extends through a rotary bearing 113 supported by a stand 114. Thus, the stand 114 supports the rotary axis 106. Thus, the stand 112 and the bearing 111 that support the rotary axis 105 desirably are metallic structures (so as to be electrically conductive). Further, the stand 112 is electrically connected with the vacuum chamber 108, which is grounded or connected to the negative electrode of a high-voltage power supply 129. By contrast, the stand 114 that supports the rotary axis 106 is desirably made of ceramic or other suitable rigid insulator material.

The respective ends of the rotary axes 105, 106 extend axially beyond the vacuum chamber 108. In the illustrated embodiment, the rotary axis 105 (shown in FIG. 2 as extending to the right from the disc 103) extends through a first magnetic-fluid-seal unit 109 located at an end of the vacuum chamber 108. The tip of the rotary axis 105 further extends through a second magnetic-fluid-seal unit 119 into a respective container 117. The distal end of the rotary axis 105 is open such that the hollow interior 100a is in fluid communication with the interior of the container 117. By contrast, the rotary axis 106 (shown in FIG. 2 as extending to the left from the disc 104) extends through a first magnetic-fluid-seal unit 124 located at an opposite end of the vacuum chamber 108. The first magnetic-fluid-seal unit 124 is insulated from the vacuum chamber 108 by an insulating material 110 disposed between the unit and the chamber. The distal end of the rotary axis 106 then extends through a magnetic-fluid-seal unit 120 into a container 118. Similar to the tip of the rotary axis 105, the tip of the rotary axis 106 is open such that the hollow interior 100a is in fluid communication with the interior of a respective container 118. The second magnetic-fluid-seal unit 120 is insulated from the container 118 by an insulating material 121 disposed between the unit and the container. The magnetic-fluid-seal units 109 and 119, 124 and 120 support the respective rotary axes 105, 106 while allowing the axes to freely rotate. Additionally, the magnetic-fluid-seal units 109 and 119, 124 and 120 provide hermetic seals to the vacuum chamber 108 and the containers 117 and 118.

A motor 115 is attached to a portion of the rotary axis 105 between magnetic-fluid-seal units 109, 119 via connecting drive coupler 128 (e.g., gears and/or belts). The motor 115 is configured to rotate the rotary axes 105, 106, thereby causing the rotary plate 100 to rotate around the center of the axes. By contrast, a portion of the rotary axis 106 between the magnetic-fluid-seal units 120, 124 is placed in rotating contact with a contact shoe 116, which is coupled to a positive side of the high-voltage power source 129. In this configuration, the ring cathodes 102c of each of the capillaries 101 are grounded through the first disc 103, the rotary axis 105, the rotary bearing 111, the stand 112, and the vacuum chamber 108. On the other hand, the ring anodes 102a of each of the capillaries 101 are electrically connected to the second disc 104, the rotary axis 106, and the positive side of the high-voltage power supply 129 through the contact shoe 116. Thus, a current is supplied to the ring anodes 102a from the power supply 129. The ring anodes 102a are electrically insulated, however, from the vacuum chamber 108 and the container 118.

The containers 117, 118 are attached to the distal ends of the rotary axes 105, 106 respectively. The containers 117, 118 are configured to store an insulating medium that may be used as a coolant (e.g., deionized water). The containers 117, 118 are in fluid communication with one another via a pump 122 and a heat exchanger 123. A coolant-circulation loop may be formed such that a fluid may flow through the elements of the X-ray generator 95 in the following order: (1) container 118; (2) rotary axis 106; (3) hollow interior 100a of rotary plate 100; (4) rotary axis 105; (5) container 117; (6) heat exchanger 123; and (7) pump 122. More specifically, whenever the pump 122 is turned on, the coolant in the container 118 is pumped into the interior of the rotary axis 106, through the hollow interior 100a of the rotary plate 100, through the interior of the other rotary axis 105, and into the container 117. From the container 117, the coolant is pumped into the heat exchanger 123 for cooling. From the heat exchanger 123, the coolant is returned to the container 118 via the pump 122, where it can once again be circulated through the circulation loop. When entering the hollow interior 100a of the rotary plate 100, the coolant may strike the flow-straightener 131 disposed within the hollow interior 100a. The flow-straightener 131 causes the coolant to flow radially outward toward the edges of the rotary plate 100 and around the capillaries 101. Thus, the capillaries 101 disposed concentrically around the rotary plate 100 are cooled more effectively.

The rotary plate 100 is covered with a cover 130 inside the vacuum chamber 108. The cover 130 has a shape substantially similar to the rotary plate 100 and is sufficiently large to enclose the rotary plate 100. The cover 130 has two disc-shaped sides respectively positioned parallel to and external of the respective discs 103, 104. The sides of the cover 130 are connected by a radial edge, which extends perpendicularly from the sides. The cover 130 is attached to the side wall of the vacuum chamber 108. Each of the sides of the cover 130 includes a centrally located opening from which the respective rotary axes 105, 106 extend axially outward. Each side of the cover 130 further defines a respective opening 133, 135, which are positioned along an X-ray discharge axis corresponding to the position of the rotary plate 100 from which the discharge units 97 emit X-ray radiation (the "discharge position"). A preliminary-ionization source 125 is also aligned along the discharge axis and is attached to the opening 133. An X-ray-emission window is located on the wall of the vacuum chamber 108 opposite the preliminary-ionization source 125. The X-ray-emission window is aligned axially with the openings 133 and 135 and the preliminary-ionization source 125. A filter 126 made of zirconium may be provided in the X-ray emission window.

In one embodiment, spark electrodes are used in the preliminary-ionization source 125. The preliminary-ionization source 125 may be synchronized with the motor 115 so that a spark discharge only occurs whenever the motor 115 moves a selected one of the discharge units 97 into the discharge position. The size of the openings 133 and 135 and the size of the X-ray emission window may be adjusted so that the UV and X-ray radiation produced by the spark discharges will not interact with any other discharge units.

A portion of the radial edge of the cover 130 defines an opening that is fluidly connected to a gas inlet 127, which connects with a gas cylinder (not shown) containing the target gas (e.g., xenon gas). Thus, the target gas can flow from the gas cylinder, through the gas inlet 127, and into a space 132 defined by the cover 130 between the cover and the rotary plate 100. Inside the space 132, the target gas can flow into the interior of the cylindrical capillaries 101. The gap between the rotary plate 100 and the opening 135 in the cover 130 is typically small. Thus, the flow of target gas from the space 132 to the interior of the vacuum chamber 108 is restricted. Also, the vacuum pump (not shown) evacuating the vacuum chamber 108 has sufficient pumping capacity to maintain a desired vacuum level in the vacuum chamber. Consequently, introducing the target gas into the space 132 does not substantially increase the pressure or density of the target gas in the vacuum container 108. Thus, the absorption of X-rays by target gas located outside the space 132 in the interior of the vacuum chamber 108 can be minimized.

An illumination-optical system (not shown) and an illuminated object (not shown) may be disposed downstream of the filter 126 (to the left of the filter 126 shown in FIG. 2). The filter 126, which may be made of zirconium, prevents the transmission of extraneous X-ray, visible, and UV radiation to the illuminated object. Additionally, the filter 126 may act as a pressure separation wall between the vacuum chamber 108 and another downstream vacuum chamber (e.g., a vacuum chamber housing the illumination-optical system).

The X-ray generator 95 operates as follows. First, a target gas is introduced from the gas inlet 127 into the space 132. The motor 115 is activated, moving one of the capillaries 101 into the discharge position where the respective axes of the capillary and the preliminary-ionization source 125 overlap. The preliminary-ionization source 125 is then activated and spark discharges that produce UV, deep-UV (DUV), and X-ray radiation are generated. The resulting beams irradiate the inner wall of the selected capillary 101, the target gas in the capillary 101, and the ring electrodes 102, thereby generating photoelectrons and ions, which cause an electric discharge to be triggered between the electrodes 102 of the capillary 101. The electric discharge produces a plasma, which generates X-ray radiation. The X-rays are directed through the opening 135 and the filter 126.

The motor 115 may be run continuously so that the rotary plate 100 is in constant motion. Thus, as one capillary finishes discharging, an adjacent capillary is moved to the discharge position where the preliminary-ionization procedure is repeated. In this manner, as subsequent capillaries are rotated into position. X-rays are caused to be emitted from the capillaries 101 to produce a desired amount of X-rays. Meanwhile, the pump 122 circulates coolant through the circulation loop described above, thereby cooling the capillaries 101 heated by the respective electric discharges occurring in them.

In the illustrated embodiment, the target gas is introduced into the space 132 through a gas inlet 127 at the radial edge of the cover 130. Alternatively, the target gas may be introduced into the space 132 through an opening in one of the disc-shaped sides of the cover 130 (*i.e.*, in a direction perpendicular to the rotary plate 100). The flow of the target gas into the space 132 may then be aligned with the capillaries 101 to promote the discharge of spent target gas from the capillaries. Thus, spent gases and any particles generated within the capillaries 101 by the plasma can be actively displaced by a supply of new target gas. The inner walls of the capillaries 101 can also be cooled by the new target gas supplied to the capillary.

In the illustrated embodiment, a DC power supply is used as the high-voltage power supply 129. Alternatively, other power supplies may be used, such as pulse-recharging or resonant-recharging circuits. With a DC power supply, current is applied continuously to the electrodes 102. If an unexpected problem occurs, (e.g., electrical conduction due to fine metal particles suspended in the space 132) unwanted electric discharges may occur within capillaries not located in the discharge position or between the discs 103, 104 of the rotary plate 100. By using pulse-recharging or resonant-recharging circuits, however, the amount of time during which current is applied to the electrodes 102 is reduced and synchronized with the preliminary-ionization source 125. In other words, the recharging circuit can be synchronized so that the voltage between the electrodes 102 of the selected capillary 101 is at a maximum during the time when the capillary is in the discharge position and the preliminary-ionization source 125 is activated.

In the illustrated embodiment, the preliminary-ionization source 125 uses spark-discharges to produce pulsed light emissions. Other discharge sources, such as corona discharges; may be used in the preliminary-ionization source 125. Further, the preliminary ionization may be accomplished using a continuous, rather than a pulsed, source. For instance, an excimer laser or RF (radio frequency) source may be used. If a continuous source is utilized, the inside of the capillary 101 is ionized and electric discharges commence upon the selected capillary being moved to the discharge position. Thus, there is no need to synchronize the preliminary-ionization source 125 with the motion of the rotary plate 100.

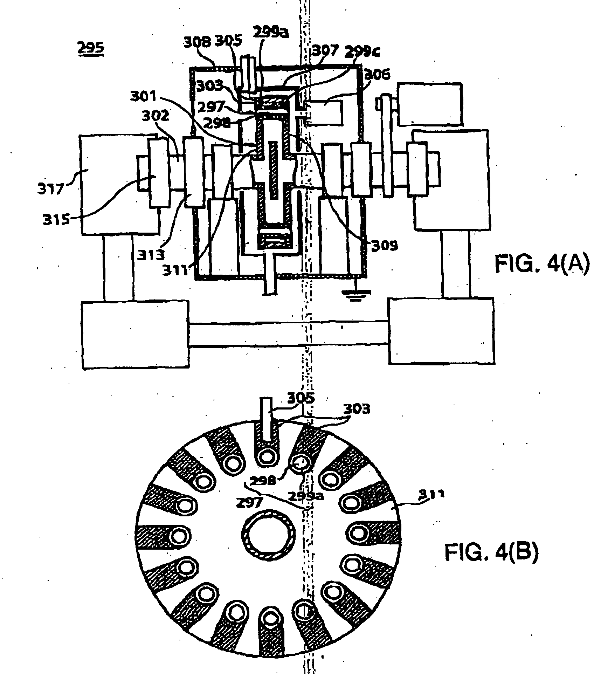

FIGS. 4(A) and 4(B) show an X-ray generator according to a third representative embodiment. Although the discharge units 297 of the X-ray generator 295 have a different structure than the discharge units of the second embodiment shown in FIG. 2, the operation of X-ray generator 295 is substantially identical to that of the X-ray generator 95 in FIG. 2. In the embodiment of FIGS. 4(A)-4(B), a disc 311 and a rotary axis 302 are made of an insulating material, such as ceramic. Because the disc 311 and the rotary axis 302 are electric insulators, they may be mounted directly to the vacuum chamber 308 and the container 317 via magnetic-fluid-seal units 313, 315. Multiple sections of conductive film 303 (e.g., gold-coated film) are affixed to the outer face of the disc 311 such that each section of conductive film is electrically connected to a respective ring anode 299a. As shown in FIG. 4(B), each section of conductive film 303 extends radially from the respective ring anode 299a to the outer edge of the disc 311.

A contact shoe 305 (shown in the upper sections of FIGS. 4(A) and 4(B)) is electrically connected to the positive side of a high-voltage power supply (not shown). The contact shoe 305 extends through the wall of the vacuum chamber 308 through a cover 307. A distal end of the contact shoe 305 is brought into slidable contact with the respective conductive film 303 of a selected capillary 298 whenever the capillary is moved into the discharge position. Because the respective conductive film 303 is electrically connected to the ring anode 299a of the selected capillary 298, the current supplied from the high-voltage power supply to the contact shoe 305 is applied to the ring anode 299a. A respective ring cathode 299c for each capillary 298 is electrically connected to a disc 309 (shown on the right side of FIG. 4 (A)) that is parallel to the disc 311. The disc 309 is made of copper and is electrically grounded as in the second embodiment. This configuration allows current to be applied selectively only to a specific capillary. Therefore, the risk that a capillary other than the desired capillary will discharge is minimized, even if an unexpected problem occurs (e.g., electrical conduction due to suspended fine metal particles or the like). Additionally, because an electric discharge occurs only in the selected capillary 298 to which current is supplied, there is no need for a preliminary-ionization source (but a preliminary-ionization source can be used if desired). If a preliminary-ionization source is used, power-supply units and circuits used for the preliminary-ionization source can be separate from the power-supply units or circuits used to produce the electric discharges in the capillaries. Alternatively, the power-supply units and circuits can be configured as part of a single discharge circuit.

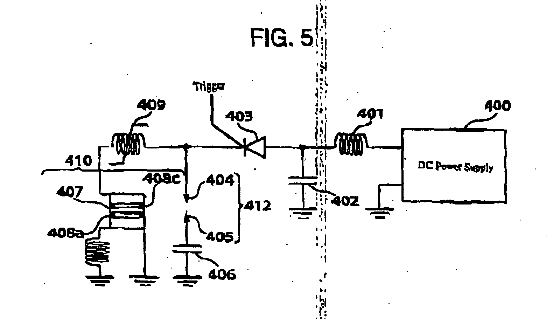

FIG. 5 is a circuit diagram showing an exemplary discharge circuit that also provides power for a preliminary-ionization source. In the circuit shown in FIG. 5, a discharge unit 410 comprises a capillary discharge X-ray source. Specifically, the discharge unit 410 comprises a capillary 407, a ring anode 408a, and a ring cathode 408c. The ring anode 408a and the ring cathode 408c are located at respective ends of the capillary 407. FIG. 5 shows only a single capillary 410, but multiple capillaries may be connected to the discharge circuit in accordance with the principles described above. The DC power supply 400 charges a capacitor 402 through an inductor 401. Once the capacitor 402 is charged to a prescribed threshold, a thyristor 403 may be triggered, thereby causing a rapid increase in the electrical potential across a pair of electrodes 404, 405. Consequently, a potential difference is created across the electrodes 404, 405, which together form spark electrodes 412. The spark electrodes 412 are used as the preliminary-ionization source. When the potential difference between the spark electrodes 412 exceeds a threshold value, an electric discharge arcs across the electrodes. The discharge causes the electrical charge stored in the capacitor 402 to move to the capacitor 406 connected to the electrode 405. The UV and X-ray radiation emitted by the discharge between the electrodes 404, 405 strikes a target gas in the capillary 407, the inner walls of the capillary, and the ring electrodes 408. As a result of the irradiation, the target gas becomes iorized.

A saturable reactor 409 is coupled between the spark electrodes 412 and the discharge unit 410. The reactor 409 is configured so that it becomes saturated, and thus its inductance reduced, once the capacitor 406 is charged and the voltage across the capacitor reaches its maximum. When the voltage across the capacitor 406 reaches maximum, the saturable reactor 409 becomes saturated, its inductance declines, and current is applied to the ring electrodes 408 of the capillary 407. The ring electrodes 408 cause an electric discharge in the capillary 407 that generates a plasma that emits the desired X-ray radiation. This circuit design simplifies the preliminary-ionization system and automatically controls the timing between the preliminary-ionization source and the electric discharge between the electrodes of the capillary 407. In an alternative embodiment, the saturable reactor 409 is omitted. In other alternative embodiments, the thyristor 403 is replaced by any of various other suitable switching devices, such as a GBIT or FET semiconductor or a thyratron.

In the type of discharge circuit shown in FIG. 5, the inductance of the discharge unit 410 should be as low as possible during discharge in order to avoid unstable discharges. Thus, the distance between the capacitor 406 and the discharge unit 410 should be minimized. One method for minimizing the distance between the capacitor 406 and the discharge unit 410 is to locate the capacitor on a movable structure to which the discharge unit is coupled.

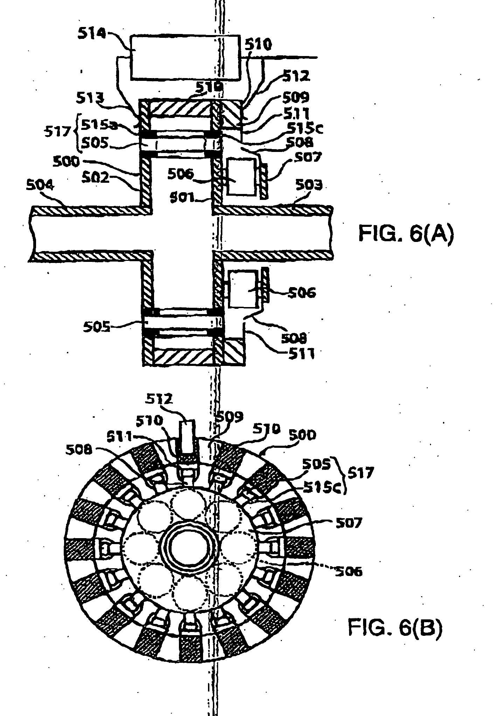

FIGS. 6(A)-6(B) depict a fourth representative embodiment wherein a discharge unit and a capacitor are mounted together onto a movable structure. A discharge unit 517 is situated on a rotary plate 500 in the manner described above with respect to FIG. 3. Further, the discharge circuit illustrated in FIG. 5 may be used to control operation of the discharge unit 517. The rotary plate 500 is a hollow body comprising a first disc 501 and a second disc 502. The discs 501, 502 are respective flat disc-shaped plates positioned opposite of and parallel to one another. The discs 501, 502 are connected to each other by a "ring wall" (ring-shaped wall) 519, extending perpendicularly from the outer periphery of the discs. The discs 501, 502 are made of a conductive metal, such as copper. Rotary axes 503, 504, which extend from the respective discs 501, 502, are also made of a conductive metal. The ring wall 519 is made of an insulative material, such as ceramic (e.g., SiC). A ring anode 515a of each capillary 505 is electrically connected to the second disc 502, whereas a ring cathode 515c is electrically connected to the first disc 501. The first disc 501 is electrically grounded through the rotary axis 503.

The poles on one side of capacitors 506 are concentrically arranged and coupled to the outer face of the first disc 501. The poles on the other side of the capacitors 506 are electrically connected to a ring-shaped metallic component 507 that is electrically insulated from the rotary axis 503. A spark-electrode pin 508 extends from the metallic component 507 to a space near the ring cathode 515c but exterior to the capillary 505. A ring-shaped insulator material 509 is disposed along the outer edge of the first disc 501. A metallic component 510 is attached to the distal face of the insulator material 509 at a position radially outward of each capillary 505. The metallic component 510 is attached across the width of the ring-shaped insulator material 509 and extends to the circumference of the disc 501. A spark-electrode pin 511 extends from the metallic component 510 to near the ring cathode 515c but exteriorly to the capillary 505. Thus, the spark-electrode pins 508, 511 both terminate in a space exterior to each ring cathode 515c and are separated from one another by a prescribed distance.

A saturable reactor 514 is positioned at the radial edge of the rotary plate 500 and separated from the edge by a prescribed distance. A first spring electrode 513 (e.g., a contact shoe) extends from one pole of the saturable reactor 514 and slidably contacts the second disc 502, which is electrically connected to the ring anodes 515a. A second spring electrode 512 (e.g., a contact shoe) extends from the other pole of the saturable reactor 514 and slidably contacts the metallic component 510, which is located on the same side of the rotary plate 500 as the ring cathodes 515c. The spring electrodes 512, 513 are positioned so that they only provide an electrical current to the electrical components associated with the selected capillary 505 in the discharge position.

The operation of the fourth embodiment is as follows. A motor (not shown) rotates the rotary plate 500. As a capillary 505 is moved into the discharge position, the thyristor 403 in the discharge circuit of FIG. 5 is triggered. The charge stored in the capacitor 402 of FIG. 5 then moves to the spark-electrode pin 511 (shown at 404 in FIG. 5) via the second spring electrode 512 and the metallic component 510. Electric discharges are produced between the spark-electrode pin 511 and the spark-electrode pin 508 (shown at 405 in FIG. 5). The charge is then transmitted to and stored in the capacitors 506 (shown at 406 in FIG. 5). The inductance of the saturable reactor 514 then decreases and the capacitors 506 discharge, causing another electrical discharge across the spark-electrode pins 508, 511. The charge is transferred through the saturable reactor 514 to the ring anode 515a of the capillary 505 (shown at 407 in FIG. 5). The charge of the ring anode 515a causes an electric discharge to occur within the capillary 505, which produces a plasma that emits X-ray radiation. Because the second spring electrode 512 is fixed at one position around the radial edge of the rotary plate 500, preliminary ionization only occurs in the capillary 505 coupled to the metallic component 510 in contact with the second spring electrode 512.

In order to ensure that an electric discharge only occurs in the capillary located in the discharge position, insulating partitions may be used to isolate the spark-electrode pins 508, 511 used during preliminary ionization. The insulating partitions prevent UV and X-ray radiation emitted during discharges across the spark-electrode pins 508, 511 from irradiating adjacent capillaries 505. Alternatively, in order to more reliability restrict the discharges, the area around each spark-electrode pin 508, 511 may be covered with an insulating cover. The inner wall of the cover may be mirrored so that the radiation emitted can be partially redirected toward the respective capillary. Thus, the overall efficiency of preliminary ionization can be enhanced.

In the illustrated embodiment, the capacitors 506 attached to the first disc 501 are electrically connected in parallel through the metallic component 507. Other electrical configurations, however, are possible. For instance, any number of capacitors (e.g., one or two) can be connected to a single spark-electrode pin 508.

In the illustrated embodiment, a current flows through the spark-electrode pins 508, 511 whenever the capacitor 506 is charged by the discharge of the capacitor 402 (FIG. 5) and whenever the inductance of the saturable reactor 514 drops. The current is typically large enough to cause the spark-electrode pins 508, 511 to melt if the circuit were operated for an extended period of time. Melting of the spark-electrode pins 508, 511 can result in an increase in the distance between the pins, thereby increasing the potential for unstable discharges. Additionally, melting of the pins 508, 511 may cause metallic powder to be released inside the cover, potentially causing unexpected electric discharges. Thus, a separate capacitor may be used only for preliminary ionization. If the circuit is configured in this manner, the capacitance of the capacitor used for preliminary ionization may be substantially smaller than the capacitance of the capacitor used for the main discharge. Consequently, the current flowing between the spark-electrode pins 508, 511 will be smaller and deterioration of the pins caused by the current flow substantially reduced.

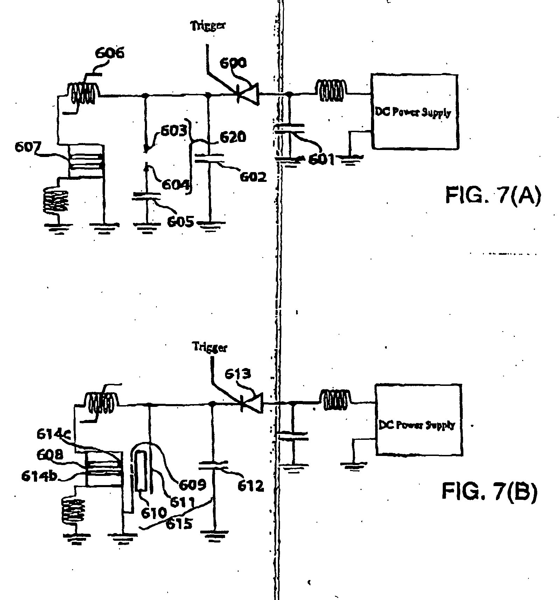

FIGS. 7(A)-7(B) show exemplary circuit diagrams for discharge circuits in which separate capacitors for preliminary ionization are provided. The circuits shown in FIGS. 7(A)-7(B) are substantially similar to the discharge circuit shown in FIG. 5. In FIG. 7(A), a capacitor 602 used for preliminary ionization is connected between a thyristor 600 and spark electrodes 620. Whenever the thyristor 600 is triggered, the charge stored in a capacitor 601 is transferred to the capacitor 602. The charge of the capacitor 602 also causes the electric potential of the spark-electrode pin 603 to increase. Whenever the potential of the capacitor 602 exceeds a threshold value, an electric discharge is produced between the spark-electrode pins 603, 604, thereby charging the capacitor 605. Whenever the potentials of the capacitors 602, 605 reach a maximum, a saturable reactor 606 becomes saturated. The charge stored in the capacitors 602, 605 then flows through the saturable reactor 606 to the electrodes of the capillary 607 and produces an electrical discharge in the capillary. Most of the current in the discharge is from the charge stored in the capacitor 602. Thus, the current between the spark-electrode pins 603, 604 can be sufficiently low to prevent damage to the pins.

In FIG. 7(B), an electrode 609 is positioned opposite a cathode 614c at the exterior of a capillary 608. The electrode 609 desirably is made of a metallic mesh and is electrically grounded. A flat metallic plate 611 is disposed opposite the mesb electrode 609. An insulator plate 610 is positioned between the plate 611 and the mesh electrode 609. The insulator plate 610 may be made, for instance, from a ceramic. The metallic plate 611 is coupled to a capacitor 612. The configuration of the mesh electrode 609, the insulator plate 610, and the metallic plate 611 creates a low-capacitance capacitor 615. Whenever a thyristor 613 is triggered, current flows to the capacitor 612 and to the metallic plate 611, thereby charging the capacitors 612, 615. Whenever the capacitor 615 has been charged to a threshold value, a corona discharge is produced between the mesh electrode 609 and the insulator plate 610, producing UV and X-ray radiation. The resulting beams irradiate the interior of the capillary 608 and ionize the target gas inside the capillary 608. A main electrical discharge is then produced in the capillary 608. In contrast to spark discharges, corona discharges produce only small amounts of fine particles and impure gases, thereby prolonging the life of the preliminary-ionization source and reducing the number of impurities that can impair operation of optical components within the vacuum chamber.

In the illustrated embodiment the mesh electrode 609 is used as a cathode of the low-capacitance capacitor 615. However, the mesh electrode 609 may also be used as the anode of the capacitor 615, in which case the mesh electrode should still be positioned near the capillary 608.

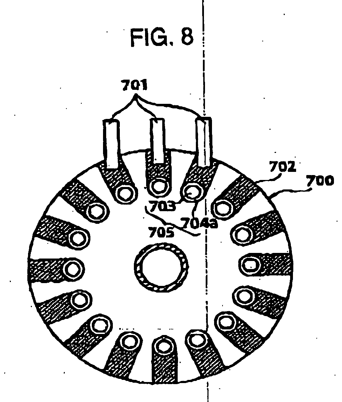

FIG. 8 depicts an X-ray generator according to a fifth representative embodiment. Unlike the embodiments described above, wherein the X-rays are emitted from a fixed position, the fifth representative embodiment is an X-ray generator capable of emitting X-rays simultaneously from a plurality of positions. In FIG. 8, a discharge unit 705 has a structure substantially similar to a discharge unit as shown in FIG. 4(B), except that a ring anode 704a may contact multiple contact shoes 701 supplying a discharge current. A conductive film 702 (e. g., a gold-coated film) is formed on the surface of a rotary plate 700. The conductive film 702 is electrically connected to the ring anode 704a of a capillary 703 and extends in an outward radial direction to the edge of the rotary plate 700. In FIG. 8, the three contact shoes 701 are connected to a high-voltage power supply (not shown) and contact the conductive film 702 of the capillaries whenever the three capillaries 703 are moved into their respective discharge positions. Thus, in the illustrated embodiment, preliminary ionization only occurs in the three capillaries 703 electrically connected to the three respective contact shoes 701 via the conductive film 702.

Each capillary 703 may be associated with a single preliminary-ionization source. Alternatively, multiple capillaries may share a single preliminary-ionization source. If one preliminary-ionization source is utilized per capillary, sources having a compact size (e.g., sources using spark-electrode pins) should be used. If one preliminary-ionization source is shared among multiple capillaries, sources having a large emission area (e.g., RF-discharge or corona-discharge sources) should be used. If multiple discharge units are to be discharged simultaneously, it may be difficult to produce simultaneous emissions using a single power source. Thus, individual energy storage units may be provided for each discharge unit.

In the illustrated embodiment, the capillaries in which discharges occur are all located adjacent to one another. Other discharge configurations, however, are possible. For instance, the X-ray generator can be configured so that discharges occur from non-adjacent capillaries (e.g., every other capillary or every third capillary).

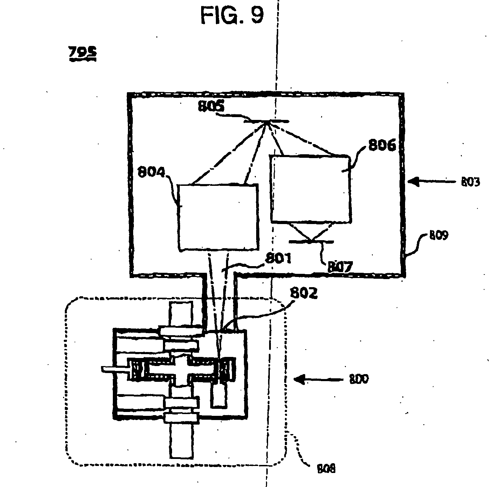

FIG. 9 shows an X-ray microlithography apparatus 795 according to a sixth representative embodiment. The depicted X-ray microlithography apparatus 795 (e.g., an X-ray stepper) comprises an X-ray generator 800, an illumination-optical system 804, and a projection-optical system 806. The illumination-optical system 804 and the projection-optical system 806 are typically enclosed in a vacuum chamber 803, in which also are placed a reflective reticle 805 and a wafer 807.

The X-ray generator 800 shown in FIG. 9 is similar to the X-ray generator of the second embodiment (FIG. 2), but any of the X-ray generators described above alternatively may be used. In the illustrated embodiment, the X-ray generator 800 uses xenon as the target gas. The X-ray emission window of the X-ray generator 800 is aligned with the vacuum chamber 809, in which the illumination-optical system 804 and the projection-optical system 806 are housed. A filter 802, provided on the X-ray-emission window, acts as a pressure-separation wall between the vacuum chamber 808 of the X-ray generator and the vacuum chamber 809 of the exposure system 803.

The illumination-optical system 804 is positioned along the discharge axis of the X-ray generator 800. The X-rays 801 emitted from the selected discharge unit in the discharge position of the X-ray generator 800 are directed through the filter 802 and into the illumination-optical system 804. The illumination-optical system 804 comprises at least one multilayer-film mirror that only reflects X-rays of certain wavelengths. The mirror may be coated, for instance, with a Mo/Si multilayer film that reflects X-rays having a wavelength near 13.4 nm. The illumination-optical system 804 also shapes the X-rays into an X-ray beam that illuminates an arc-shaped region on a reflective reticle 805. The reflective reticle 805 is configured so that, at each illumination position, the X-ray intensity is at full numerical aperture (NA) for the system. The reflective reticle 805 typically is configured as a multilayer-film mirror. The projection-optical system 806 demagnifies the image carried by the X-ray beam reflected from the reticle 805 and focuses the image onto the wafer 807 or other suitable substrate 807 coated with a suitable resist. The demagnification ratio of the projection-optical system 806 may be, for instance, five to one. During this process, patterns that are defined by the reflective reticle 805 (e.g., layers of an integrated circuit or other microelectronic device) are transferred to the resist. The projection-optical system 806 also comprises at least one mirror coated with a multilayer film (e.g., Mo/Si).

The X-ray generator 800 of the X-ray microlithography apparatus 795 desirably comprises multiple discharge units disposed on a rotary plate. The rotation of the rotary plate causes the sequential emission of X-rays from the discharge units. The ratio of discharges from an individual discharge unit to the number of total discharges from the X-ray generator is $\frac{1}{N}$, where N is the number of discharge units on the rotary plate. Thus, in comparison to an X-ray generator using only one discharge unit, the X-ray generator of the present embodiment has a higher repeat frequency, thereby improving overall system throughput.

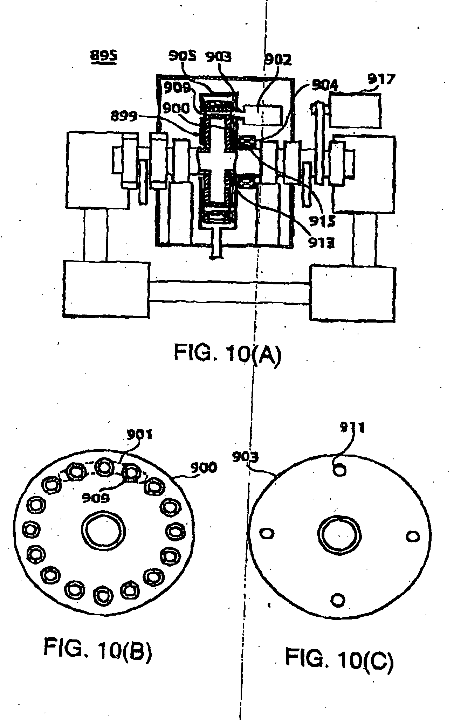

FIGS. 10(A)-10(C) depict an X-ray generator according to a seventh representative embodiment. In the seventh representative embodiment, the X-ray-discharge position is not fixed but is instead movable (e.g., in a scanning motion). The X-ray generator 895 shown in FIG. 10(A) is similar to the X-ray generator of the second embodiment (FIG. 2).

As shown in FIG. 10(B), discharge units 909 may emit X-ray radiation across scanning area 901. The scanning area 901 may correspond, for example, to an arc-shaped illumination area of the reflective reticle in the X-ray stepper. In this embodiment, the shape and size of the opening in the cover 905 and the X-ray-emission window for the vacuum container are modified to correspond with the scanning area 901.

In the illustrated embodiment, a corona discharge is produced in the preliminary-ionization source 902. The emission area resulting from the corona discharge may be equal in size to the scanning area 901. As noted above, a corona discharge has a broader emission area than a spark discharge and produces fewer fine particles and impure gases. Thus the life of a preliminary-ionization source is prolonged and the number of impurities produced is minimized.

Also included in the illustrated embodiment is a rotary screen 903. The rotary screen 903 is disposed between the preliminary-ionization source 902 and a disc 900 of the rotary plate 899. The rotary screen 903 may be made, for example, of aluminum. As shown in FIG. 10(C), four concentric openings 911 may be formed at equiangular intervals on the rotary screen 903. The rotary screen 903 and the disc 900 have substantially identical diameters, and the four openings 911 of the rotary screen 903 are concentrically aligned with the discharge units 909 of the disc 900. The rotary screen 903 is coupled to a rotary axis 915 that surrounds the rotary axis 913. The rotary axis 915 has the same axial center as the rotary axis 913, but has a larger diameter. The rotary axis 915 is equipped with a rotary-drive system 904 (e.g., a motor) separate from the motor 917 used to drive the rotary axis 913. The rotary-drive system 904 rotates the rotary screen 903 on the same axis as the rotary plate 899, but at a different rotational frequency.

The X-ray generator 895 operates as follows, The rotary-drive system 904 rotates the rotary screen 903 so that, when the selected discharge unit 909 is moved to the edge of the scanning area 901, one of the openings 911 is axially aligned with the selected unit 909. Preliminary ionization and X-ray emission then occurs. As the motor 917 rotates continuously, another discharge unit 909 is moved to a position in the scanning area 901 slightly shifted from the previous X-ray emission position. The rotary-drive system 904 then rotates the rotary screen 903 so that another one of the openings 911 is axially aligned with the new discharge unit 909 at the new position. Then, preliminary ionization and X-ray emission occur again. The respective rotational speeds of the motor 917 and the rotary-drive system 904 may be set so that the desired timing is obtained and the scanning area 901 is scanned from edge-to-edge. The respective rotary speeds of the motor 917 and the rotary-drive system 904, however, need not be constant. Instead, the respective speeds can be varied to ensure the desired scanning motion through the scanning area.

In the illustrated embodiment, the scanning area of the emission unit has a scale similar to that of the illumination area on the reflective reticle. Thus, the illumination-optical system can be configured to reduce the scanning area by only a small amount (e.g., one-half). Other relationships between the scanning area and the illumination area, however, may exist. Further, the structure of the illumination-optical system can be simplified because there is no need for providing a separate scanning mechanism in the system.

In one alternative embodiment, the width of the scanning area (measured as a distance perpendicular to the scanning direction) may be larger than the size of the X-ray emission from the emission unit (measured as being approximately one-half the inner diameter of the emission-unit capillary). In this case, a mechanism capable of moving the discharge unit in the radial direction of the disc 900 may be provided. For instance, the entire X-ray generator 895 may be mounted on a linear stage and moved in a radial direction of the disc 900. Accordingly, the reflective reticle can be illuminated in both the scanning direction and in a direction perpendicular to the scanning direction.

Although the discharge units of the illustrated embodiment are positioned concentrically on the rotary disc 900, they may have varying radial positions. Further, a mechanism that moves the rotary plate 899 in a direction along its rotary axis can be provided to correct for aberrations in the illumination-optical system. Additionally, the X-ray generator 895 may be configured so that multiple discharge units produce simultaneous X-ray emissions within the scanning area. For instance, as is shown in FIG. 10(B), two or three discharge units may be used to produce simultaneous emissions in the scanning area 901. Using simultaneous emissions can reduce the amount of time needed to scan the reflective reticle and improve throughput.

In any of the above embodiments, various discharge units other than a capillary X-ray source may be used. For instance, hollow cathode-type sources, Z-pinch-type sources, or plasma focus-type sources may be used. Additionally, mechanisms other than a preliminary-ionization source may be used to trigger the electric discharges between the electrodes of the discharge units. For instance, any preliminary-ionization source creating a signal capable of ensuring the stable discharge of the discharge units may be used (e.g., the application of high-voltage pulses). Further, the X-ray generators of the above embodiments may be configured such that the discharge units move in a non-rotary direction. For instance, the discharge units can be configured to move along a straight line or in a curved direction.

When operated for a long period of time, discharge units may exhibit unstable discharges due to the deterioration of electrodes. Consequently, the intensity of X-rays produced may decrease. Thus, it is desirable for the rotary plates of the above embodiments to be detachable from the X-ray generator. The discharge units can then be quickly replaced and the overall operational efficiency of the X-ray source improved. The individual discharge units may also be configured to be removable from the rotary plate. Thus, only the deteriorated discharge units can be removed and replaced. As a result, the rotary plates can be reused and the overall running cost of the system reduced.

Any of the above embodiments may also include a detector (e.g., a photointerrupter type of rotary encoder) that monitors the rotational angle of the rotary plate. The detector may be used to maintain a fixed rotation angle and/or to provide feedback regarding the rotational speed of the rotary plate. Based on the rotational angle of the plate, the detector can be used to trigger the preliminary ionization or main electric discharge of the discharge units. By synchronizing the rotational speed of the rotary plate with the preliminary ionization and electrical discharges, the accuracy and reliability of the X-ray generator can be optimized.

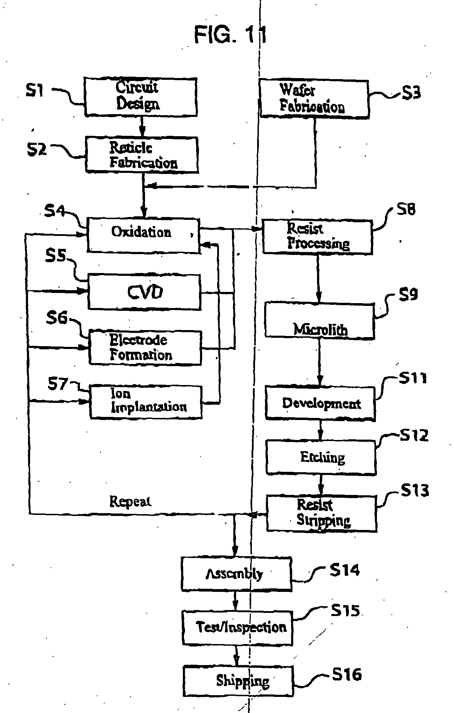

FIG. 11 is a flow chart of steps in a process for manufacturing a microelectronic device such as a semiconductor chip (e.g., an integrated circuit or LSI device), a display panel (e.g., liquid-crystal panel), charged-coupled device (CCD), thin-film magnetic head, micromachine, for example. In step S1, the circuit for the device is designed. In step S2 a reticle ("mask") for the circuit is manufactured. In step S2, local resizing of pattern elements can be performed to correct for proximity effects or space-charge effects during exposure. In step S3, a wafer is manufactured from a material such as silicon.

Steps S4-S13 are directed to wafer-processing steps, in which the circuit pattern defined on the reticle is transferred onto the wafer by microlithography. Step S14 is an assembly step (also termed a "post-process" step) in which the wafer that has been passed through steps S4-S13 is formed into semiconductor chips. This step can include, e.g., assembling the devices (dicing and bonding) and packaging (encapsulation of individual chips). Step S15 is an inspection step in which any of various operability and qualification tests of the device produced in step S14 are conducted. Afterward, devices that successfully pass step S15 are finished, packaged, and shipped (step S16).

Steps S4-S13 also provide representative details of wafer processing. Step S4 is an oxidation step for oxidizing the surface of a wafer. Step S5 involves chemical vapor deposition (CVD) for forming an insulating film on the wafer surface. Step S6 is an electrode-forming step for forming electrodes on the wafer (typically by vapor deposition). Step S7 is an ion-implantation step for implanting ions (e.g., dopant ions) into the wafer. Step S8 involves application of a resist (exposure-sensitive material) to the wafer. Step S9 involves microlithographically exposing the resist using X-rays to imprint the resist with the reticle pattern of the reticle produced in step S2. In step S9, an X-ray generator or exposure method as described above can be used. Step S11 involves developing the exposed resist on the wafer. Step S12 involves etching the wafer to remove material from areas where developed resist is absent. Step S13 involves resist separation, in which remaining resist on the wafer is removed after the etching step. By repeating steps S4-S13 as required, circuit patterns as defined by successive reticles are formed superposedly on the wafer.

Whereas the invention has been described in connection with multiple representative embodiments, it will be understood that the invention is not limited to those embodiments. On the contrary, the invention is intended to encompass all modifications, alternatives, and equivalents included within the spirit and scope of the invention, as defined by the appended claims.

The features disclosed in the foregoing description, in the claims and/or in the accompanying drawings may, both separately and in any combination thereof, be material for realising the invention in diverse forms thereof.

## Claims

1. A radiation-generating device, comprising:

   a movable substrate; and
   multiple discharge units mounted to the movable substrate, each discharge unit having respective first and second electrodes situated relative to each other such that a current flowing between the first and second electrodes forms a plasma from a target gas situated between the electrodes and causes the plasma to emit radiation,

   wherein the movable substrate is controllably movable such that a selected one of the multiple discharge units is moved into a discharge position.

2. A device according to Claim 1, wherein the radiation is X-ray radiation.

3. A device according to Claim 1 or 2, further comprising a synchronization mechanism coupled to the respective first and second electrodes of the multiple discharge units, the synchronization mechanism being configured to control a timing with which the discharge units are energized so that only a selected discharge unit is energized at the discharge position.

4. A device according to any preceding claim, wherein the substrate is electrically grounded and electrically coupled to one of the respective first and second electrodes of the multiple discharge units.

5. A device according to any preceding claim, further comprising:

   an X-axis stage to which the movable substrate is mounted, the X-axis stage being configured to move the substrate along an X-axis; and
   a Y-axis stage to which the movable substrate is mounted, the Y-axis stage being configured to move the substrate along a Y-axis.

6. A device according to any preceding claim, comprising multiple preliminary-ionization sources coupled to the movable substrate, a selected one of the multiple preliminary ionization sources being situated relative to the selected discharge unit at the discharge position such that the selected preliminary-ionization source energizes the target gas in the selected discharge unit.

7. A device according to Claim 6, wherein the selected preliminary-ionization source provides preliminary for multiple discharge units simultaneously.

8. A device according to any one of Claims 1 to 5, comprising a preliminary-ionization source positioned adjacent the movable substrate and facing the discharge axis, the preliminary-ionization source being configured to energize the target gas in the selected discharge unit at the discharge position.

9. A device according to Claim 8, further comprising a discharge circuit connected to the electrodes and to the preliminary-ionization source, the discharge circuit being configured to delay delivery of current to the electrodes of the selected discharge unit until after the preliminary-ionization source preliminarily has energized the target gas in the selected discharge unit.

10. A device according to Claim 8 or 9, wherein the preliminary-ionization source utilizes a spark discharge.

11. A device according to Claim 8 or 9, wherein the preliminary-ionization source utilizes a corona discharge.

12. A device according to Claim 8 or 9, wherein the preliminary-ionization source utilizes a continuous discharge.

13. A radiation-generating device, comprising:

   multiple movable substrates; and
   a respective at least one discharge unit attached to each of the multiple movable substrates, each discharge unit having respective first and second electrodes situated relative to each other such that a current flowing between the electrodes forms a plasma from a target gas situated between the electrodes and causes the plasma to emit radiation,

   wherein the movable substrates are controllably movable such that a selected one of the multiple discharge units is moved into a discharge position.

14. A device according to Claim 13, wherein the radiation is X-ray radiation.

15. A device according to Claim 13 or 14, further comprising a synchronization mechanism coupled to the respective first and second electrodes of the multiple discharge units, the synchronization mechanism being configured to control a timing with which the discharge units are energized so that only a selected discharge unit is energized at the discharge position.

16. A device according to any one of Claims 13 to 15, further comprising multiple preliminary-ionization sources coupled to the multiple movable substrates; wherein a selected one of the multiple preliminary-ionization sources is situated relative to the selected discharge unit at the discharge position such that the selected preliminary-ionization source energizes the target gas in the selected discharge unit.

17. A device according to Claim 16, wherein the selected preliminary-ionization source provides preliminary ionization for multiple discharge units simultaneously.

18. A device according to any one of Claims 13 to 15, further comprising a preliminary-ionization source aligned with the discharge axis, the preliminary-ionization source being configured to energize the target gas in the selected discharge unit at the discharge position.

19. A device according to Claim 18, further comprising a discharge circuit connected to the electrodes and to the preliminary-ionization source, the discharge circuit being configured to delay delivery of current to the electrodes of the selected discharge unit until after the preliminary-ionization source has energised the target gas in the selected discharge unit.

20. A device according to Claim 18 or 19, wherein the preliminary-ionization source utilizes a spark discharge.

21. A device according to Claim 18 or 19, wherein the preliminary-ionization source utilizes a corona discharge.

22. A device according to Claim 18 or 19, wherein the preliminary-ionization source utilizes a continuous discharge.

23. A radiation-generating device, comprising:

   a rotary plate that rotates about a rotation axis; and
   multiple discharge units coupled to the rotary plate, each discharge unit having respective first and second electrodes situated relative to each other such that a current flowing between the electrodes forms a plasma from a target gas situated between the electrodes and causes the plasma to emit radiation,

wherein the rotary plate is controllably rotatable such that a selected one of the multiple discharge units rotates into a discharge position.

**24.** A device according to Claim 23, wherein the radiation is X-ray radiation.

**25.** A device according to Claim 23 or 24, further comprising multiple preliminary-ionization sources attached to the rotary plate, wherein a selected one of the multiple preliminary-ionization sources is situated relative to the selected discharge unit at the discharge position such that the selected preliminary-ionization source energizes the target gas in the selected discharge unit.

**26.** A device according to Claim 25, wherein the selected preliminary-ionization source provides preliminary ionization for two or more discharge units simultaneously.

**27.** A device according to Claim 23 or 24, further comprising a preliminary-ionization source located adjacent a first side of the rotary plate and facing the discharge axis, the preliminary-ionization source being configured to energize the target gas in the selected discharge unit at the discharge position.

**28.** A device according to Claim 27, further comprising a discharge circuit connected to the electrodes and to the preliminary-ionization source, the discharge circuit being configured to delay delivery of current to the electrodes of the selected discharge unit until after the preliminary-ionization source preliminarily has energized the target gas in the selected discharge unit.

**29.** A device according to Claim 27 or 28, wherein the preliminary-ionization source utilizes a spark discharge.

**30.** A device according to Claim 27 or 28, wherein the preliminary-ionization source utilizes a corona discharge.

**31.** A device according to Claim 27 or 28, wherein the preliminary-ionization source utilizes a continuous discharge.

**32.** A device according to any one of Claims 23 to 31, wherein:

the rotary plate comprises first and second discs positioned parallel to and opposite each other;

the first disc and the second disc are separated by a ring-shaped wall; and
the multiple discharge units are positioned between the first disc and second disc of the rotary plate.

**33.** A device according to any one of Claims 23 to 31, wherein the rotary plate defines a hollow interior, the device further comprising:

a first rotary axis attached to a first side of the rotary plate, the first rotary axis extending outwardly from the first side along the rotation axis and terminating at a first end; and
a second rotary axis attached to an opposite second side of the rotary plate, the second rotary axis extending outwardly from the second side along the rotation axis in a direction opposite to the first rotary axis and terminating at a second end,
the first and second rotary axes being configured to transport a fluid to the discharge units and being fluidly connected with the hollow interior of the rotary plate.

**34.** A device according to Claim 33, further comprising:

a pump fluidly connected to the first end of the first rotary axis; and
a heat exchanger fluidly connected to the second end of the second rotary axis and to the pump,
the pump being configured to continuously circulate the fluid through the first rotary axis, the hollow interior of the rotary plate, the second rotary axis, and the heat exchanger.

**35.** A device according to Claim 34, wherein the fluid is a coolant.

**36.** A device according to any one of Claims 33 to 35, further comprising a flow-straightener disposed centrally within the hollow interior of the rotary plate and having a diameter smaller than that of the rotary plate.

**37.** A device according to any one of Claims 23 to 36, further comprising:

a cover that defines a space enclosing at least a portion of the rotary plate and comprises a gas inlet; and
a gas supply coupled to the gas inlet of the cover and configured to introduce the target gas into the space.

**38.** A device according to Claim 37, wherein the cover defines a discharge opening at a portion of the cover adjacent the discharge position.

39. A device according to any one of Claims 23 to 38, wherein the discharge position is a discharge area across which the selected discharge unit can emit radiation in a scanning motion.

40. A device according to Claim 39, further comprising a rotary cover, the rotary cover defining multiple openings disposed on a circle concentric with the rotary cover and being configured to move in a coordinated manner with the rotary plate such that radiation emissions from the multiple discharge units are in the scanning motion.

41. A device according to Claim 39 or 40, further comprising a moving mechanism situated and configured for moving the selected discharge unit in a direction radial to the rotary plate.

42. A device according to Claim 39, further comprising a rotary cover, the rotary cover defining multiple openings disposed on a circle concentric with the rotary cover and being configured to move in a coordinated manner with the rotary plate such that a first discharge unit is preliminarily energized via a respective opening in the rotary cover to emit radiation, and a second discharge unit is preliminarily energized at a different position than the first discharge unit via a respective opening in the rotary cover to emit radiation, thereby producing consecutive radiation collectively forming an emission region similar to an illumination region of an illumination-optical system.

43. A device according to any one of Claims 23 to 42, wherein the selected discharge unit is a first selected discharge unit arid the discharge position is a first discharge position, the rotary plate being further configured to move a second selected discharge unit to a second discharge position and to energize the second selected discharge unit simultaneously with the first selected discharge unit.

44. A device according to any one of Claims 23 to 43, further comprising a synchronization mechanism coupled to the electrodes of the multiple discharge units, the synchronization mechanism being configured to control a timing with which the multiple discharge units are energized so that only a selected discharge unit is energized.

45. A radiation-generating device, comprising:

multiple discharge units, the discharge units having respective first and second electrodes situated relative to each other such that a respective current applied to a respective pair of first and second electrodes forms a plasma from a target gas situated between the pair of electrodes and causes the plasma to emit radiation; and
means for supplying current to the respective pairs of electrodes in the discharge units in a sequential manner.

46. A radiation-generating device, comprising:

multiple discharge units, the discharge units having first and second electrodes situated relative to each other such that a respective current supplied to a respective pair of first and second electrodes forms a plasma from a target gas situated between the pair of electrodes and causes the plasma to emit radiation; and
a synchronization mechanism configured to control a timing with which the discharge units are energized so that only a selected one of the multiple discharge units is energized in a discharge position.

47. A microlithography apparatus, comprising the radiation-generating device of any preceding claim.

48. A microelectronic device manufactured by the apparatus of any preceding claim.

49. A method for generating radiation, comprising:

selecting a discharge unit from multiple discharge units mounted on a movable substrate;
moving the movable substrate such that the selected discharge unit is in a discharge position; and
energising the selected discharge unit sufficiently to cause the selected discharge unit to emit radiation.

50. A method according to Claim 49, further comprising synchronizing the energization so that only the selected discharge unit in the discharge position is energized.

51. A method according to Claim 49 or 50, further comprising cooling the multiple discharge units by circulating a coolant through the movable substrate.

52. A method according to any one of Claims 49 t0 51, further comprising energizing a target gas situated in the selected discharge unit with a preliminary-ionization source.

53. A method according to Claim 52, wherein the step of energizing the discharge occurs after the step of energizing the target gas.

**54.** A method according to any one of Claims 49 to 53, wherein the movable substrate is in continuous motion.

**55.** A method according to any one of Claims 49 to 54, wherein:

the movable substrate is a rotary plate; and the step of moving the substrate comprises rotating the rotary plate such that the selected discharge unit is in the discharge position.

**56.** A method according to any one of Claims 49 to 56, wherein the selected discharge unit is a first selected discharge unit and the discharge position is a first discharge position, the method further comprising:

selecting a second discharge unit from the multiple discharge units mounted on the movable substrate; moving the movable substrate such that the second selected discharge unit is in a second discharge position; and energizing the second selected discharge unit sufficiently to cause the second selected discharge unit to emit radiation.

**57.** A method according to Claim 56, wherein the first and second discharge positions are the same.

**58.** A method according to Claim 56, wherein the first and second discharge positions are positioned along a scanning direction.

**59.** A method according to Claim 58, further comprising the step of synchronizing the moving of the movable substrate such that the first and second selected discharge units are moved sequentially along the scanning direction.

**60.** A method according to any one of Claims 56 to 59, wherein:

the first and second selected discharge units are simultaneously moved to the first and second discharge positions; and the first and second selected discharge units are energized in the respective first and second discharge positions.

**61.** A method for generating radiation, comprising:

selecting a first discharge unit from at least one discharge unit mounted on a first movable substrate; moving the first movable substrate such that the first discharge unit is in a first discharge position; selecting a second discharge unit from at least one discharge unit mounted on a second movable substrate; and moving the second movable substrate such that the second discharge unit is in a second discharge position.

**62.** A method according to Claim 61, wherein the first and second movable substrates are in continuous motion.

**63.** A method according to Claim 61 or 62, wherein the first and second discharge positions are the same.

**64.** A method according to Claim 61 or 62, wherein the first and second discharge positions are situated along a scanning direction.

**65.** A method according to Claim 64, further comprising the step of synchronizing the moving of the first and second movable substrates such that the first and second selected discharge units are moved sequentially along the scanning direction.

**66.** A method according to any one of Claims 61 to 65, further comprising the step of synchronizing the moving of the first and second movable substrates such that the first and second discharge units are moved simultaneously into the respective first and second discharge positions.

FIG. 1(A)

FIG. 1(B)

FIG 2

97

101

102 100

103,104

100b

**FIG. 3(A)**

97

102a 101 102c

**FIG. 3(B)**

FIG. 4(A)

FIG. 4(B)

FIG. 5

FIG. 6(A)

FIG. 6(B)

FIG. 7(A)

FIG. 7(B)

FIG. 8

FIG. 9

795

805

806

804

803

801

802

807

809

800

808

FIG. 10(A)

FIG. 10(B)

FIG. 10(C)

FIG. 11